# EUROPEAN PATENT SPECIFICATION

(11) **EP 2 472 351 B1**
(45) Date of publication and mention of the grant of the patent: **13.03.2013**
(21) Application number: 10016233.8
(22) Date of filing: 31.12.2010
(51) Int. Cl.: G06F 1/20

(54) **A method for controlling a cooling system and a cooling system**
Verfahren zur Steuerung eines Kühlsystems und Kühlsystem
Procédé de contrôle d'un système de refroidissement et système de refroidissement

(43) Date of publication of application: 04.07.2012
(73) Proprietor: Advanced Digital Broadcast S.A., 1292 Chambesy (CH)
(72) Inventor: Pszonka, Tomasz, 65-119 Zielona Góra (PL)
(74) Representative: Pawlowski, Adam

(56) References cited:
- US-A1- 2002 020 755
- US-A1- 2002 140 389
- US-A1- 2006 162 340
- US-B1- 6 414 843

## Description

The present invention relates to control of cooling systems, in particular systems for cooling heat generating devices, especially electronic devices, for example processors, hard disk drives, memories, integrated circuit chips and the like.

A typical cooling system arrangement for electronic devices comprises a fan or water cooling mounted in proximity or in contact with the heat generating electronic device in order to decrease its temperature when such decrease is required.

Usually such system operates for a given predefined period of time or operates to decrease temperature to a predefined threshold such as five degrees less than the temperature at which the cooling is switched on.

Commonly the cooling system has high cooling capabilities in order to react rapidly to undesirable thermal conditions.

Such rapid cooling may however be not preferred, because rapid cooling causes thermal strain or stress to electronic circuits. There are certain requirements from integrated circuits manufacturers that define, for example, that a particular device should not be heated or cooled more than fifteen degrees per hour in addition to its maximum operating temperature limit. Such strict thermal requirements influence the methods and systems for cooling electronic devices. If these requirements are not followed it may result in circuits wear and increased probability of breaking down or malfunctioning.

Cooling systems presently on market cannot fulfill the foregoing requirements because the cooling system is separated from the cooled device. In another words, at design or production stage of the cooling system it is not known what kind of electronic circuit will be cooled by it, i.e. a particular type of processor, memory, other integrated circuit chip or device such as a hard disk or a tuner.

The following prior art follows the aforementioned rapid cooling. US pregrant patent application publication number 2002020755 entitled "Computer system and method of controlling rotation speed of cooling fan" discloses a computer system comprising a first heat generating element in which a heat generation amount is changed; a second heat generating element; a fan configured to cool the first and second heat generating elements; a first temperature sensor configured to detect a temperature of the first heat generating element; a second temperature sensor configured to detect a temperature of the second heat generating element; and a controller configured to control a rotation speed of the cooling fan, based on the temperatures detected by the first and second temperature sensors.

Additionally, the current cooling systems frequently switch on and off because of the defined mode of cooling by several degrees as described above. This further increases the frequency of the thermal strain to the circuits and electronic devices.

The aim of the present invention is to provide a method and a system for cooling electronic devices that will minimize the thermal strain caused by the rapid and repetitive cooling and heating.

In an exemplary embodiment it is also a more detailed aim of the present invention to achieve minimization of the thermal strain while utilizing only a single temperature sensor.

It is also the aim of the present invention to lower the noise generated by fan cooling systems.

The object of the invention is a method for controlling a cooling system for cooling a heat generating device, the method comprising the steps of determining cooling capabilities of the cooling system as a temperature decrease that can be achieved by the cooling system alone while the heat generating device operates in constant conditions after reaching a maximum temperature at the constant ambient conditions; determining an activation temperature; measuring the temperature of the heat generating device; switching the cooling system on when the measured temperature reaches the activation temperature; defining a deactivation temperature which is smaller by a threshold value than the activation temperature minus the cooling capabilities; switching the cooling system off when the measured temperature reaches the deactivation temperature.

The threshold value can be from 1 to 5 degrees.

The threshold value can be from 5% to 25% of the cooling capabilities.

The method may further comprise the step of adapting the cooling capabilities to the available cooling power.

The object of the invention is also a computer program comprising program code means for performing all the steps of the method according to the invention when said program is run on a computer, as well as a computer readable medium storing computer-executable instructions performing all the steps of the method according to the invention when executed on a computer.

Another object of the present invention is a cooling system comprising a cooling device for cooling a heat generating device controlled by a controller, the controller comprising a first register for storing the value of cooling capabilities of the cooling system as a temperature decrease that can be achieved by the cooling system alone while the heat generating device operates in constant conditions after reaching a maximum temperature at the constant ambient conditions; a second register for storing an activation temperature; a third register for storing a threshold value; a temperature reader for receiving a temperature of the heat generating device ; a cooling device activator configured to activate the cooling device when the temperature of the heat generating device reaches the activation temperature and to deactivate the cooling device when the temperature of the heat generating device reaches the activation temperature minus the cooling capabilities and minus the threshold value.

The temperature reader can be configured to read temperature from a temperature sensor embedded in the heat generating device

The object of the invention is also a cooling arrangement comprising a plurality of cooling devices according to the invention for cooling distinct heat-generating devices, and further comprising a coordinator for monitoring the activity status of the heat-generating devices and distributing the cooling power among the cooling devices.

The coordinator can be configured to adapt the value of cooling capabilities in the first register of each controller to the cooling power available to its controlled cooling device.

The present invention will be shown by means of an exemplary embodiment on a drawing, in which:
Figs. 1A-1B show examples of cooling systems;
Fig. 2 shows results of measured operating conditions; and
Fig. 3 shows a process of cooling system operation.
Fig. 4 shows a cooling arrangement for a multi-device system.

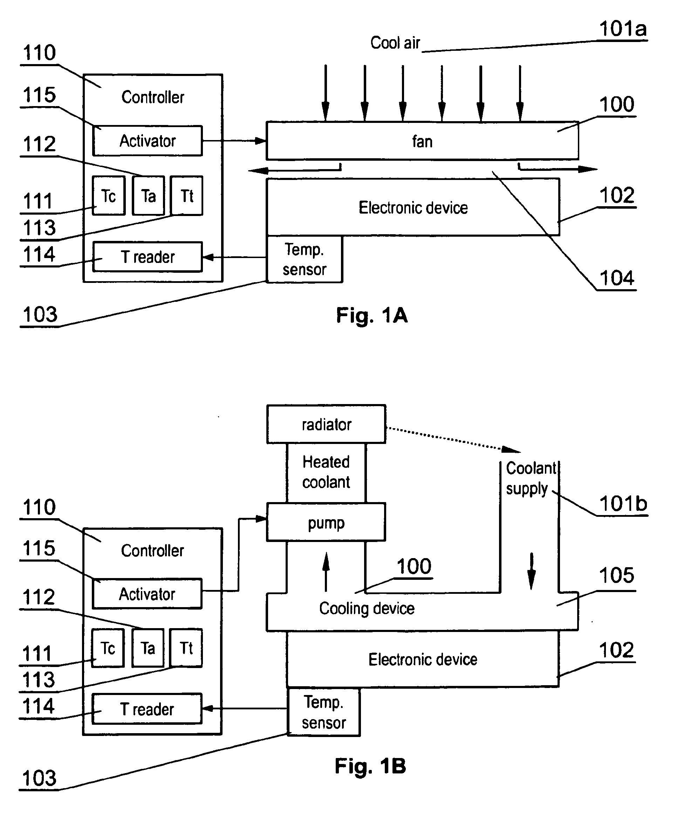

Fig. 1A and 1B show examples of cooling systems. Both systems use for cooling a cooling medium 101 a, 101b that can receive, absorb or extract heat generated by an electronic device 102 and/or the surrounding environment. The cooling medium, such as cool air 101a, may be provided to an area 104 in the vicinity of the electronic device 102. Alternatively, the cooling medium such as cool liquid, e.g. water, may be flowing within a body 105 of the cooling system in touch or in proximity to the electronic device 102.

In case of the system of Fig. 1A, the electronic device 102 is cooled by means of a cooling device 100 that is a fan and in case of the system of Fig. 1 B the electronic device 102 is cooled by means of a cooling device 100 that is a water cooling system.

The current temperature of the electronic device 102 is monitored by a temperature sensor 103. The temperature sensor 103 may be external to the electronic device 102 or it can be embedded in the electronic device and provide its measurement for reading by a data transmission port. Typically, the sensor is provided a part of the electronic device 102 by its manufacturer in order to more precisely detect temperature of the most sensitive components of the device 102.

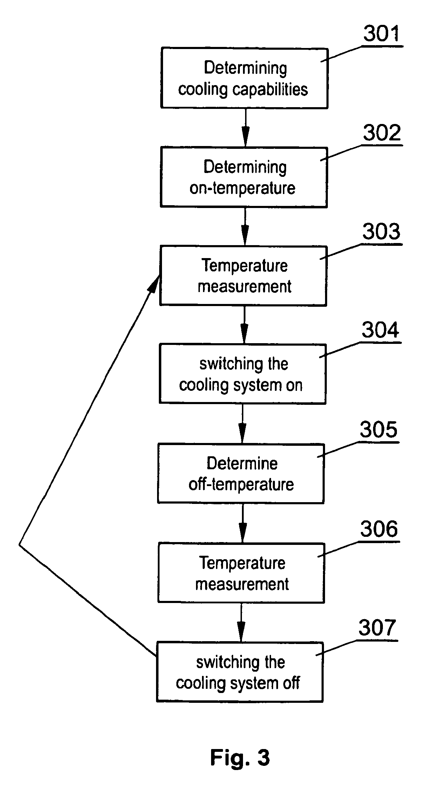

The cooling system according to the invention comprises a controller 110 for monitoring the temperature of the heat-generating device 102 and controlling the cooling device 100 according to the method shown in Fig. 3.

Technological developments result in electronic products continuing to reduce their size. There is a persistent effort to reduce the size of the integrated circuits (IC) found therein. At reduced dimensions, the heat sensitivity of the circuits increases because of small feature size and thin wafers that distort easily.

The problem of thermal sensitivity is most pronounced with processor chips, which develop considerable heat during normal operation. Such chips are mounted within an IC package. During considerable load, the heat generated by the IC is dissipated through the package's solder joints to the main circuit board as well as through the package's lid.

In addition to ICs, other electronic devices such as hard disk drives suffer from similar heat sensitivity during operation. A method of heat dissipation is required to maintain the integrity of these electronic components.

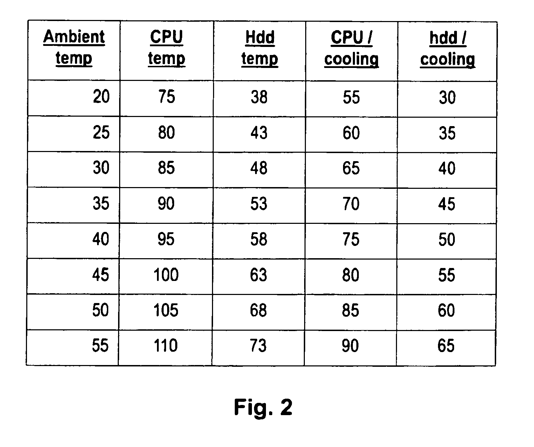

Figs. 2 shows results of measured operating conditions of a typical electronic device having a number of components mounted within a chassis. The table presents different temperature levels for a given load of an exemplary processor chip (CPU) and an exemplary hard disk drive. The temperature has been measured for different levels of ambient temperature. The ambient temperature is a temperature of a region from which the coolant is supplied, for example the temperature of the room from which the air is to the interior of electronic device's chassis.

The first column of the table shows the ambient temperature. The second and the third column show respectively the temperature of the CPU and of the hard disk drive when the cooling system is inactive. The fourth and the fifth column show respectively the temperature of the CPU and of the hard disk drive when the cooling system is active and the temperature has dropped to the minimum level achievable by the cooling system.

Experiments have shown that regardless of the ambient temperature, the electronic equipment will heat by a constant temperature, above the ambient temperature, under constant load conditions. For example, at ambient temperature of 20 degrees the tested CPU will heat by 55 degrees to 75 and will heat also by 55 degrees to 110 degrees when operating in ambient conditions of 55 degrees. Correspondingly, the tested hard disk drive has increased its temperature by 18 degrees over the ambient temperature at different levels of the ambient temperature.

Assuming a high ambient volume outside the tested device, the ambient temperature remains constant during heating of the tested device (when the device operates) and remains constant during a subsequent cooling phase (when the device operates and the cooling system is turned on). For a constant ambient temperature, the cooling system used can cool the tested CPU by 20 degrees and the tested hard disk drive by 8 degrees, regardless of the particular constant level of the ambient temperature. All experiments have been performed using Celsius scale but other temperature scales apply correspondingly.

Such finding is used in the present invention to design a method for cooling system control and a cooling system. It can be recognized from the above results that the activation temperature, i.e. the temperature for which the cooling system is switched on, may be reached when only ambient conditions have changed. Taking this into account an event triggering cooling system switch off can also relate to ambient conditions change for more favorable. However, it is also of special advantage of the present invention not to use an additional temperature sensor to detect that ambient conditions have actually changed to more preferable levels.

Fig. 3 shows a process of cooling system operation, which is controlled by the controller 110. Specifically, it depicts steps of a method for a cooling system control for cooling a heat generating device. An electronic device is a specific example of the heat generating device. Other examples include non-electronic devices such as engines or radiators.

First, the method starts in step 301 by determining cooling capabilities of the cooling system as a temperature decrease that can be achieved by the cooling system alone for the cooled device while the heat generating device operates in constant conditions after reaching a given temperature at the constant conditions. Referring to Fig. 2, the cooling capabilities of the cooling system are equal to 8 degrees for the hard disk drive and 20 degrees for the tested CPU. The given temperature needs to be higher than the ambient temperature plus the cooling capabilities, which in unknown conditions may be estimated.

The cooling capabilities may be constant or change, depending e.g. on the amount of the cooling medium available in the system. The cooling capabilities are stored in the first register 111 of the cooling controller 110.

At step 302 the system determines an activation temperature depending on the heat generating device characteristics. The activation temperature is a temperature at which the cooling system should be switched on in order to maintain operating parameters required by a manufacturer of the electronic device being cooled. The activation temperature is stored in the second register 112 of the cooling controller 110.

Starting from step 303, constant or interval-based measuring of the temperature of the heat generating device is commenced by a temperature reader 114. For example, the temperature reader can read the temperature from the temperature sensor 103 embedded in the device 102. When the heat generating device increases its temperature, the cooling system is switched on in step 304 by an activator 105 when the measured temperature reaches the activation temperature.

Preferably prior to, or in proximity to step 304, the system shall also determine a deactivation temperature in step 305. The deactivation temperature is a temperature lower by a threshold value than the activation temperature minus the cooling capabilities. Therefore, the deactivation temperature can only be reached when conditions unrelated to the cooling system have changed, since activating the cooling system, such that less heat is present or can be generated, than is necessary to reach the on-temperature by the heat generating device when the cooling system is deactivated after cooling the heat generating device by at least a temperature equal to cooling capabilities. In other words, when the cooled device reaches the deactivation temperature, the cooling system can be safely switched off without the risk that the device will heat up to the activation temperature, provided that the ambient conditions nor the device operating conditions will not change. In that case, the system is switched off by the activator 115 in step 307 when it is detected in step 306 that the heat-generating device 102 reaches the deactivation temperature, i.e. is cooled from the activation temperature by more than the cooling capabilities. Therefore, the activator 115 is configured to deactivate the cooling device 100 when the temperature of the heat generating device 102 reaches the activation temperature minus the cooling capabilities and the threshold value. Afterwards, the system returns to monitoring the subsequent increase of the temperature above the activation temperature in step 303.

The threshold value is stored in the third register 113. The threshold value can be specified as absolute value, for example from 1 to 5 degrees. Alternatively, the threshold value can be specified as a percentage of the cooling capabilities, for example from 5% to 25%.

For example, with reference to Fig. 2, the activation temperature for the CPU can be set at for example 80 degrees. The corresponding deactivation temperature will be less than 60 degrees, e.g. 59 degrees (less than activation temperature - cooling capabilities). Assuming that the ambient temperature is 25 degrees, the cooling system will be activated after the device temperature reaches the activation temperature of 80 degrees and next the device will be subsequently cooled to 60 degrees. Assuming that the ambient temperature remains constant and the device operates under constant conditions (e.g. the CPU performs the same type of computational operations), the cooling system will remain active and the device temperature will be kept at 60 degrees. Only when the ambient temperature will decrease to 24 degrees or less, or if the operating conditions of the device change (e.g. the CPU stops performing some of the computational operations or the hard disk is turned off), the temperature of the CPU will drop to 59 degrees, i.e. it will reach the deactivation temperature and the cooling system will be deactivated. Then, if the operating conditions of the device remain constant and the ambient temperature remains not higher than 24 degrees, the CPU will heat up to 79 degrees and stay at this temperature, which will not make it necessary to activate the cooling system. Therefore, a single sensor of the temperature of the device is enough to control the operation of the cooling system.

By requiring the temperature of the cooled device to drop below the activation temperature minus the cooling capabilities of the cooling system, the cooling system gradient of cooling can be adjusted to the heat generating devices manufacturers requirements with respect to speed of cooling. Also with the use of the foregoing arrangements, the cooling system is switched on and off less frequently, which reduces the thermal strain applied to electronic circuits of the heat generating devices.

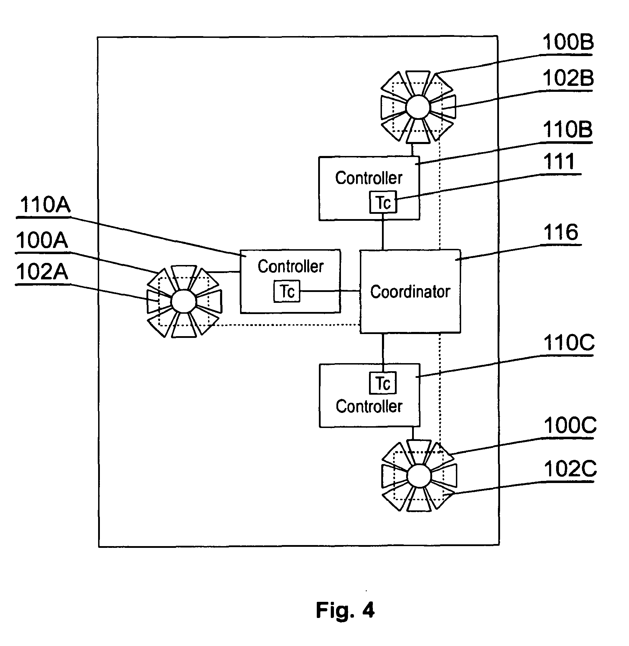

Fig. 4 shows a cooling arrangement for a multi-device system, such as a computer in which a plurality of heat-generating devices, such as a processor, a dedicated graphic processing chip and a hard disk are embedded in a single chassis. The cooling arrangement comprises three cooling devices 100A, 100B, 100C, each for cooling a distinct heat-generating device 102A, 102B, 102C. The cooling devices are supplied with a coolant from a common source 100D, such as common liquid pump (the cooling liquid flow conduits not shown to improve the clarity of the drawing). In case the cooling devices 100A-100C are the same, the cooling power of each device is equal to 1/3 of the total cooling power. In case one device is switched off, for example when a hard disk is deactivated and does not require cooling, the cooling power of the remaining devices increases to ½ of the total cooling power. The cooling power determines the cooling capabilities - the higher the cooling power, the higher the temperature decrease that can be achieved by the cooling system. Therefore, the cooling arrangement may comprise a cooling coordinator 116 for monitoring the activity status of the heat-generating devices 102A-102C and distributing the cooling power among the cooling devices 100A-100C, for example by deactivating the cooling devices assigned to inactive heat-generating devices and directing the flow of coolant to the other cooling devices. Accordingly, the cooling coordinator 116 may adapt the values of the cooling capabilities in the first register 111 of each controller 110A-110C to the cooling power available to its controlled cooling device. By such configuration, the cooling arrangement may actively adapt to the operation of the multi-device system.

It can be easily recognized, by one skilled in the art, that the aforementioned system and method for controlling a cooling system may be performed and/or controlled by one or more computer programs. Such computer programs are typically executed by utilizing the computing resources of a processing unit which can be embedded within various video signal receivers, such as personal computers, personal digital assistants, cellular telephones, receivers and decoders of digital television, video display units or the like. The computer programs can be stored in a non-volatile memory, for example a flash memory or in a volatile memory, for example RAM and are executed by the processing unit. These memories are exemplary recording media for storing computer programs comprising computer-executable instructions performing all the steps of the computer-implemented method according the technical concept presented herein.

## Claims

1. A method for controlling a cooling system for cooling a heat generating device, the method comprising the steps of:
- determining an activation temperature (302);
- measuring the temperature of the heat generating device (303);
- switching the cooling system on (304) when the measured temperature reaches the activation temperature;
- defining a deactivation temperature;
- switching the cooling system off (307) when the measured temperature (306) reaches the deactivation temperature;
the method being **characterised in that** it further comprises the steps of
o determining cooling capabilities (301) of the cooling system as a temperature decrease that can be achieved by the cooling system alone while the heat generating device operates in constant conditions after reaching a maximum temperature at the constant ambient conditions;
o defining the deactivation temperature (305) which is smaller by a threshold value than the activation temperature minus the cooling capabilities.

2. The method according to claim 1, wherein the threshold value is from 1 to 5 degrees.

3. The method according to claim 1, wherein the threshold value is from 5% to 25% of the cooling capabilities.

4. The method according to claim 1, further comprising the step of adapting the cooling capabilities to the available cooling power.

5. A computer program comprising program code means for performing all the steps of the method according to any of claims 1-3 when said program is run on a computer.

6. A computer readable medium storing computer-executable instructions performing all the steps of the method according to any of claims 1-3 when executed on a computer.

7. A cooling system comprising a cooling device (100) for cooling a heat generating device (102) controlled by a controller (110), the controller (110) comprising:
- a first register (112) for storing an activation temperature;
- a second register (113) for storing a threshold value;
- a temperature reader (114) for receiving a temperature of the heat generating device (102);
- a cooling device activator (115) configured to activate the cooling device (100) when the temperature of the heat generating device (102) reaches the activation temperature and to deactivate the cooling device (100) when the temperature of the heat generating device (102) reaches the activation temperature minus the threshold value
the cooling system being **characterized in that** the cooling system further comprises
- a third register (111) for storing the value of cooling capabilities of the cooling system as a temperature decrease that can be achieved by the cooling system alone while the heat generating device (102) operates in constant conditions after reaching a maximum temperature at the constant ambient conditions;
- wherein the cooling device activator (115) is to deactivate the cooling device (100) when the temperature of the heat generating device (102) reaches the activation temperature minus the cooling capabilities and minus the threshold value.

8. The cooling system according to claim 7, wherein the temperature reader (114) is configured to read temperature from a temperature sensor (103) embedded in the heat generating device (102)

9. A cooling system comprising a plurality of cooling devices (100A, 100B, 100C) according to claim 7 for cooling distinct heat-generating devices (102A, 102B, 102C), and further comprising a coordinator (116) for monitoring the activity status of the heat-generating devices (102A, 102B, 102C) and distributing the cooling power among the cooling devices (100A, 100B, 100C).

10. The cooling system according to claim 9, wherein the coordinator (116) is configured to adapt the value of cooling capabilities in the first register (111) of each controller (110A, 110B, 110C) to the cooling power available to its controlled cooling device (100A, 100B, 100C).

## Patentansprüche

1. Verfahren zum Steuern/Regeln eines Kühlsystems zum Kühlen einer Wärme erzeugenden Vorrichtung, wobei das Verfahren die Schritte umfasst:
- Bestimmen einer Aktivierungstemperatur (302);
- Messen der Temperatur der Wärme erzeugenden Vorrichtung (303);
- Einschalten des Kühlsystems (304), wenn die gemessene Temperatur die Aktivierungstemperatur erreicht;
- Definieren einer Deaktivierungstemperatur;
- Ausschalten des Kühlsystems (307), wenn die gemessene Temperatur (306) die Deaktivierungstemperatur erreicht;
wobei das Verfahren **dadurch gekennzeichnet ist, dass** es ferner die Schritte umfasst:
- Bestimmen von Kühlfähigkeiten (301) des Kühlsystems als eine Temperaturabnahme, die durch das Kühlsystem allein erreicht werden kann, während die Wärme erzeugende Vorrichtung unter konstanten Bedingungen arbeitet, nach Erreichen einer Maximaltemperatur bei den konstanten Umgebungsbedingungen;
- Definieren der Deaktivierungstemperatur (305), die um einen Schwellenwert kleiner ist als die Aktivierungstemperatur minus den Kühlfähigkeiten.

2. Das Verfahren nach Anspruch 1, worin der Schwellenwert von 1 bis 5 Grad ist.

3. Das Verfahren nach Anspruch 1, worin der Schwellenwert von 5% bis 25% der Kühlfähigkeiten ist.

4. Das Verfahren nach Anspruch 1, das ferner den Schritt umfasst, die Kühlfähigkeiten an die verfügbare Kühlleistung anzupassen.

5. Computerprogramm, das Programmcodemittel aufweist, um alle die Schritte des Verfahrens gemäß einem der Ansprüche 1 - 3 durchzuführen, wenn das Programm auf einem Computer läuft.

6. Computerlesbares Medium, das computerausführbare Anweisungen speichert, die alle die Schritte des Verfahrens gemäß einem der Schritte 1 - 3 durchführt, wenn es auf einem Computer ausgeführt wird.

7. Kühlsystem, das eine von einem Controller (110) gesteuerte/geregelte Kühlvorrichtung (100) zum Kühlen einer Wärme erzeugenden Vorrichtung (102) aufweist, wobei der Controller (110) umfasst:
- ein erstes Register (112) zum Speichern der Aktivierungstemperatur;
- ein zweites Register (113) zum Speichern eines Schwellenwerts;
- einen Temperaturleser (114) zum Erhalten einer Temperatur der Wärme erzeugenden Vorrichtung (102);
- einen Kühlvorrichtungsaktivator (115), der konfiguriert ist, um die Kühlvorrichtung (110) zu aktivieren, wenn die Temperatur der Wärme erzeugenden Vorrichtung (102) die Aktivierungstemperatur erreicht, und um die Kühlvorrichtung (110) zu deaktivieren, wenn die Temperatur der Wärme erzeugenden Vorrichtung (102) die Aktivierungstemperatur minus dem Schwellenwert erreicht,
wobei das Kühlsystem **dadurch gekennzeichnet ist, dass** das Kühlsystem ferner umfasst:
- ein drittes Register (111) zum Speichern des Werts von Kühlfähigkeiten des Kühlsystems als Temperaturabnahme, die durch das Kühlsystem allein erreicht werden kann, während die Wärme erzeugende Vorrichtung (102) unter konstanten Bedingungen arbeitet, nach Erreichen einer Maximaltemperatur bei den konstanten Umgebungsbedingungen;
- worin der Kühlvorrichtungsaktivator (115) die Kühlvorrichtung (100) aktiviert, wenn die Temperatur der Wärme erzeugenden Vorrichtung (102) die Aktivierungstemperatur minus den Kühlfähigkeiten und minus dem Schwellenwert erreicht.

8. Das Kühlsystem nach Anspruch 7, worin der Temperaturleser (114) konfiguriert ist, um die Temperatur von einem Temperatursensor (103) zu lesen, der in die Wärme erzeugende Vorrichtung (102) eingebettet ist.

9. Kühlsystem, das eine Mehrzahl von Kühlvorrichtungen (100A, 100B, 100C) gemäß Anspruch 7 zum Kühlen von bestimmten Wärme erzeugenden Vorrichtungen (102A, 102B, 102C) aufweist, und das ferner einen Koordinator (116) aufweist, um den Aktivitätszustand der Wärme erzeugenden Vorrichtungen (102A, 102B, 102C) überwachen und um die Kühlleistung unter den Kühlvorrichtungen (100A, 100B, 100C) zu verteilen.

10. Das Kühlsystem nach Anspruch 9, worin der Koordinator (116) konfiguriert ist, um den Wert der Kühlfähigkeiten in dem ersten Register (111) jedes Controllers (110A, 110B, 110C) an die Kühlleistung anzupassen, die an seiner gesteuerten/geregelten Kühlvorrichtung (100A, 100B, 100C) verfügbar ist.

## Revendications

1. Procédé de contrôle d'un système de refroidissement pour refroidir un dispositif calogène, le procédé comprenant les étapes suivantes :
- détermination d'une température d'activation (302) ;
- mesure de la température du dispositif calogène (303) ;
- allumage du système de refroidissement (304) lorsque la température mesurée atteint la température d'activation ;
- définition d'une température de désactivation ;
- extinction du système de refroidissement (307) lorsque la température mesurée (306) atteint la température de désactivation ;
le procédé étant **caractérisé en ce qu'**il comprend en outre les étapes suivantes :
- détermination des capacités de refroidissement (301) du système de refroidissement telle qu'une diminution de température qui peut être obtenue par le système de refroidissement seul alors que le dispositif calogène fonctionne dans des conditions constantes après avoir atteint une température maximale aux conditions ambiantes constantes ;
- définition de la température de désactivation (305) qui est inférieure d'une valeur de seuil à la température d'activation moins les capacités de refroidissement.

2. Procédé selon la revendication 1, dans lequel la valeur de seuil est de 1 à 5 degrés.

3. Procédé selon la revendication 1, dans lequel la valeur de seuil est de 5 % à 25 % des capacités de refroidissement.

4. Procédé selon la revendication 1, comprenant en outre l'étape d'adaptation des capacités de refroidissement au pouvoir réfrigérant disponible.

5. Programme informatique comprenant des moyens de codage de programme pour réaliser toutes les étapes du procédé selon l'une quelconque des revendications 1 à 3 lorsque ledit programme est exécuté sur un ordinateur.

6. Support lisible par ordinateur stockant des instructions exécutables par ordinateur réalisant toutes les étapes du procédé selon l'une quelconque des revendications 1 à 3 lorsqu'il est exécuté sur un ordinateur.

7. Système de refroidissement comprenant un dispositif de refroidissement (100) pour refroidir un dispositif calogène (102) contrôlé par un contrôleur (110), le contrôleur (110) comprenant :
- un premier registre (112) pour stocker une température d'activation ;
- un deuxième registre (113) pour stocker une valeur de seuil ;
- un lecteur de température (114) pour recevoir une température du dispositif calogène (102) ;
- un activateur de dispositif de refroidissement (115) configuré pour activer le dispositif de refroidissement (100) lorsque la température du dispositif calogène (102) atteint la température d'activation et pour désactiver le dispositif de refroidissement (100) lorsque la température du dispositif calogène (102) atteint la température d'activation moins la valeur de seuil ;
le système de refroidissement étant **caractérisé en ce qu'**il comprend en outre
- un troisième registre (111) pour stocker la valeur de capacités de refroidissement du système de refroidissement telle qu'une diminution de température qui peut être obtenue par le système de refroidissement seul alors que le dispositif calogène (102) fonctionne dans des conditions constantes après avoir atteint une température maximale aux conditions ambiantes constantes ;
- dans lequel l'activateur de dispositif de refroidissement (115) sert à désactiver le dispositif de refroidissement (100) lorsque la température du dispositif générant de la chaleur (102) atteint la température d'activation moins les capacités de refroidissement et moins la valeur de seuil.

8. Système de refroidissement selon la revendication 7, dans lequel le lecteur de température (114) est configuré pour lire la température à partir d'un capteur de température (103) intégré au dispositif calogène (102).

9. Système de refroidissement comprenant une pluralité de dispositifs de refroidissement (100A, 100B, 100C) selon la revendication 7 pour refroidir des dispositifs calogènes distincts (102A, 102B, 102C) et comprenant en outre un coordinateur (116) pour surveiller l'état d'activité des dispositifs calogènes (102A, 102B, 102C) et répartir le pouvoir réfrigérant entre les dispositifs de refroidissement (100A, 100B, 100C).

10. Système de refroidissement selon la revendication 9, dans lequel le coordinateur (116) est configuré pour adapter la valeur des capacités de refroidissement dans le premier registre (111) de chaque contrôleur (110A, 110B, 110C) au pouvoir réfrigérant disponible pour son dispositif de refroidissement contrôlé (100A, 100B, 100C).
